## Europäisches Patentamt
**European Patent Office**
**Office européen des brevets**

(19)

(11) Numéro de publication: **0 056 783 B1**

(12) **FASCICULE DE BREVET EUROPEEN**

(45) Date de publication du fascicule du brevet:
**27.12.84**

(51) Int. Cl.³: **H 03 H 9/13,** G 04 F 5/06

(21) Numéro de dépôt: **82810006.5**

(22) Date de dépôt: **08.01.82**

(54) **Micro-résonateur piézo-électrique.**

(30) Priorité: **15.01.81 CH 234/81**

(43) Date de publication de la demande:
**28.07.82 Bulletin 82/30**

(45) Mention de la délivrance du brevet:
**27.12.84 Bulletin 84/52**

(84) Etats contractants désignés:
**DE FR GB NL**

(56) Documents cités:
**DE - A - 2 939 844**
**DE - C - 763 329**
**FR - A - 2 325 093**
**US - A - 3 906 260**

(73) Titulaire: **ASULAB S.A., Faubourg du Lac 6,**
**CH-2502 Bienne (CH)**

(72) Inventeur: **Dinger, Rudolf, Charrières 7,**
**CH-2024 St-Aubin (CH)**
Inventeur: **Michel, Jean-Georges, Observatoire 44,**
**CH-2000 Neuchâtel (CH)**

(74) Mandataire: **Dronne, Guy, ASUAG Département Brevets**
**et Licences Faubourg du Lac 6, CH-2501 Bienne (CH)**

ACTORUM AG

## Description

La présente invention a pour objet un micro-résonateur piézo-électrique.

De façon plus précise, l'invention concerne un micro-résonateur piézo-électrique vibrant selon un mode principal d'extension-compression et muni d'un ensemble de fixation et de suspension ne formant qu'une pièce avec le barreau.

Les micro-résonateurs piézo-électriques enforme de barreaux sont bien connus. Ils sont constitués par un barreau sensiblement parallélépipédique, en quartz par exemple, qui comporte deux faces respectivement supérieures et inférieures et deux flancs, et par des électrodes qui sont disposées sur le barreau. Ces électrodes, reliées à une source de tension alternative, créent dans le matériau piézo-électrique des champs électriques dont les directions sont fixées par la position des électrodes. Par ailleurs, il est bien connu que ce champ électrique produit des contraintes dans le cristal dont la direction dépend de la direction des champs électriques créés dans le cristal par rapport aux axes ducristal. Comme cela est bien connu, on distingue par exemple pour le quartz, l'axe optique Z et des systèmes d'axes orthogonaux constitués chacun par une axe électrique X et un axe mécanique Y contenus dans un plan perpendiculaire à l'axe Z. On dit qu'un barreau piézo-électrique est de coupe Z lorsque les faces supérieures et inférieures du barreau sont sensiblement perpendiculaires à l'axe optique Z. Bien entendu, de nombreuses autres coupes sont possibles, mais l'invention concerne le cas de barreaux piézo-électriques de coupe au voisinage de la coupe Z.

Ces micro-résonateurs piézo-électriques ont de nombreuses applications en particulier pour la réalisation de garde-temps. De tels garde-temps dans la réalisation de circuits oscillants formant les bases de temps pour des ordinateurs ou pour des montres électroniques. Dans le cas des montres les résonateurs utilisés sont logés dans des boîtiers étanches dont les dimensions doivent être aussi réduites que possible. Le résonateur doit donc lui-même avoir des dimensions très réduits. En outre, dans les montres, la seule source d'énergie électrique est une pile qui alimente en particulier le résonateur. Pour augmenter la durée de vie de la pile, il faut donc utiliser des composants ayant une consommation aussi réduite que possible. C'est bien sûr le cas du résonateur dont l'entretien doit nécessiter aussi peu d'énergie électrique que possible. Or, la quantité d'énergie nécessaire est d'autant plus élevée que le facteur de qualité est bas. En outre, le circuit électronique amplificateur nécessaire pour l'entretien de l'oscillateur doit avoir un haut rendement pour transformer l'énergie fournie par la pile en un signal périodique en phase avec la vibration du résonateur. La réalisation sous forme intégrée d'un tel circuit à très faible consommation est rendue difficile lorsque le couplage piézo-électrique du résonateur est faible. Ce couplage peut se mesurer par la capacité dynamique ($C_1$) du résonateur. Cette valeur $C_1$ pour le barreau de coupe Z travaillant en extension-compression muni de système d'électrodes selon l'invention est donnée par la formule:

$$C_1 = \frac{1}{127} \epsilon_0 \, \epsilon_r \frac{L}{w} \, t$$

dans laquelle $\epsilon_r$ est la constante diélectrique du matériau utilisé; L est la longueur de l'électrode, W la distance séparant les deux flancs du barreau (largeur) et t la distance séparant les faces supérieure et inférieure (épaisseur).

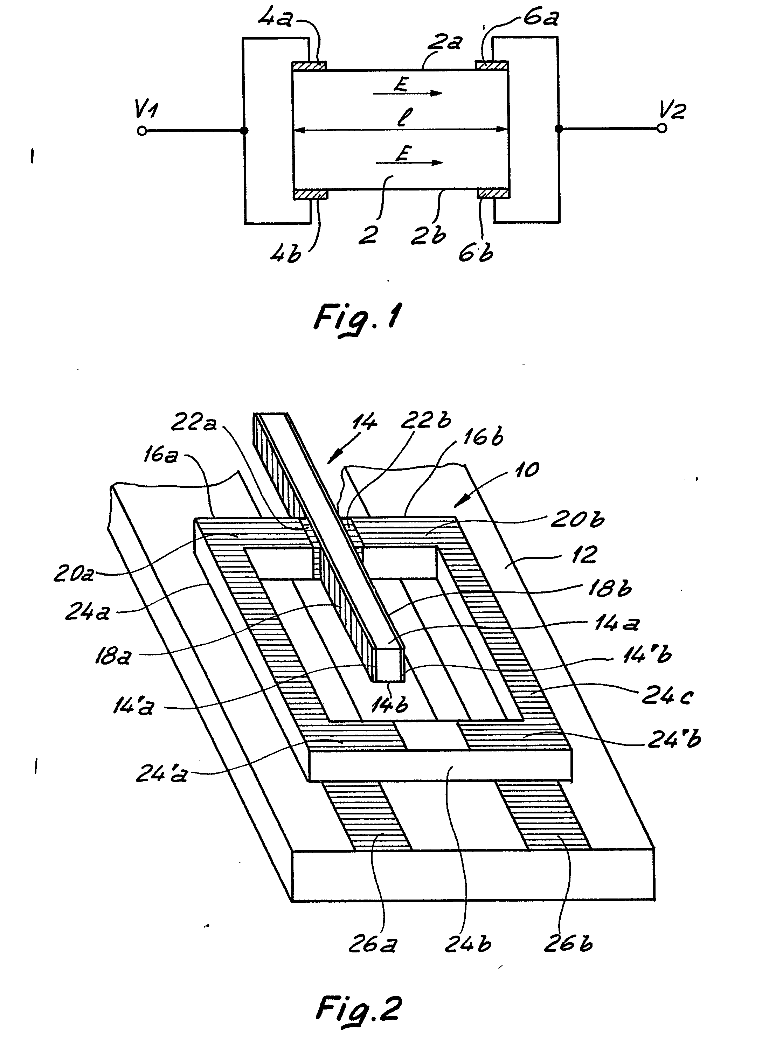

On connaît déjà, par le brevet suisse 600 423, un résonateur piézo-électrique en forme de barreau et muni de bras de suspension qui vibre en extension-compression. Ce résonateur est représenté de façon simplifiée en coupe transversale sur la figure 1 annexée. Le barreau 2 dont les faces 2a et 2b sont parallèles au plan XY est muni de deux électrodes 4a et 6a sur les bords de la face supérieure 2a et de deux électrodes 4b et 6b sur sa face inférieure 2b, ces électrodes étant parallèles à la direction Y. En portant les électrodes 4a et 4b à un même potentiel $V_1$ et les électrodes 6a et 6b à unautre potentiel $V_2$, on crée dans le barreau un champ électrique E ayant une composante non nulle selon l'axe X.On obtient ainsi un résonateur quivibre en extension-compression selon l'axe X. En outre, le barreau étant perpendiculaire à l'axe Z, il est aisé de le tailler par attaque chimique avec un excellent précision. Cependant, l'excitation obtenue à l'aide de la composante du champ électrique parallèle à l'axe X est faible. Cela signifie que la capacité dynamique d'un tel résonateur est faible, de l'ordre de 0,1 fF, rendant ainsi très délicate la réalisation d'un oscillateur stable à très faible consommation.

On connaît également des résonateurs réalisés par des procédés mécaniques ayant des électrodes sur les faces perpendiculaires à l'axe X pour obtenir un couplage piézo-électrique suffisant. Cependant ces résonateurs ne comportant pas d'ensemble de fixation faisant partie intégrant du barreau, leur montage dans le boîtier doit se faire par des fils conducteurs soudés sur les faces du résonateur. Un tel montage est évidemment difficile et ne se prête pas à une fabrication en série.

Pour remédier à ces inconvénients, un premier objet de l'invention est de fournir un résonateur piézo-électrique en forme de barreau de coupe Z et muni d'un ensemble de fixation intégré qui présente un couplage piézo-électrique élevé, équivalent à celui d'un quartz de type DT.

Un deuxième objet de l'invention est de fournir un tel résonateur qui soit réalisable par des procédés simples et compatibles avec une fabrication en grandes séries, en particulier par usinage chimique.

Un troisième objet de l'invention est de fournir un tel résonateur présentant une plage de fréquence qui puisse aller de 0,5 M Hz (limite supérieure des diapasons) à environ 4 M Hz (limite inférieure des quartz économiques en coupe AT).

Pour atteindre ces buts, l'invention consiste à partir d'un barreau sensiblement de coupe Z muni d'un ensemble de fixation et à réaliser une métallisation sur chaque flanc du barreau pour former deux électrodes créant ainsi un champ électrique parallèle à l'axe X.

Il est clair que le barreau étant de coupe Z, son usinage ainsi que celui des bras de suspension est aisé par des techniques de gravure chimique. De plus, comme le champ électrique créé par les électrodes est effectivement parallèle à l'axe X le couplage piézo-électrique est élevé, et la consommation électrique pour l'entretien de l'oscillation est réduite. Du fait que le champ électrique doit être parallèle à l'axe X, la définition des bords des métallisations réalisées sur les flancs du barreau n'a pas besoin d'être faite avec une grande précision. Il n'est pas critique qu'une très légère métallisation se produise sur les bords des faces supérieure ou inférieure. Enfin, comme il n'y a pas de métallisation fonctionnelle sur les faces supérieure et inférieure du barreau, la largeur du barreau, c'est-à-dire la distance entre les deux flancs du barreau peut être réduite. Il en découle une réduction des dimensions du barreau et une amélioration supplémentaire de la capacité dynamique $C_1$.

Selon une variante de réalisation, les métallisations sur les 2 flancs peuvent former un nombre n impair de paires d'électrodes se faisant face. En permutant la polarisation des paires délectrodes consécutives, il est possible, pour une longueur donnée L du barreau d'obtenir des fréquences de travail:

$f' = n \cdot f_o$, $f_o$ étant la fréquence du barreau muni d'une seule électrode sur chacun de ses flancs. Cette fréquence $f_o$ pour le quartz est donnée en kHz par la formule $f_o = \dfrac{2750}{L}$ , dans laquelle L est exprimé en mm.

D'autres caractéristiques et avantages de l'invention apparaîtront plus clairement à la lecture de la description qui suit de plusieurs modes de réalisation de l'invention, donnés à titre d'exemples non limitatifs. La description se réfère au dessin sur lequel:

la figure 1, déjà décrite, est une vue en coupe transversale d'un résonateur selon l'art antérieur;

la figure 2, est une vue en perspective d'un premier mode de réalisation du résonateur selon l'invention, le résonateur étant monté sur un support;

la figure 3, illustre le plan de coupe de la plaque de quartz servant à réaliser les résonateurs selon l'invention;

les figures 4a et 4b illustrent le mode d'excitation des résonateurs selon l'invention;

la figure 5 illustre sous une forme simplifiée une variante de réalisationdu résonateur pour obtenir des fréquences de travail plus élevées; et

les figures 6a et 6b sont des vues de dessus et en coupe verticale selon l'axe BB d'une plaque de quartz illustrant un procédé de réalisation des résonateurs selon l'invention.

La figure 2 montre en perspective un résonateur 10 selon l'invention, monté sur un support 12.

Le résonateur comprend un barreau 14 sensiblement parallélépipédique en quartz ou en tout autre matériau piézo-électrique convenable. Il comprend également un système de fixation et de suspension constitué par deux bras de suspension 16a et 16b raccordés au barreau sensiblement au milieu de sa longueur. Le barreau 14 et les bras 16a et 16b sont taillés dans une même plaque de quartz. Le barreau 14 comprend deux faces 14a et 14b, respectivement supérieure et inférieure et deux flancs 14'a et 14'b à l'exception bien entendu des zones de raccordement des bras 16a et 16b. En revanche, les faces 14a et 14b sont totalement dépourvues de métallisation ou, du moins, pratiquement totalement dépourvues de métallisation, comme on l'expliquera ultérieurement. Les faces supérieures des bras 16a et 16b sont également recouvertes d'une métallisation 20a, 20b raccordées respectivement aux métallisations 18a et 18b par des métallisations de raccordement 22a et 22b. Les bras sont avantageusement prolongés par des éléments de cadre 24a, 24b et 24c complétant l'ensemble de fixation sur le support 12. Ces éléments comportent bien sûr des métallisations 24'a et 24'b électriquement reliées à des pistes conductrices 26a et 26b déposées sur le support 12. Ce cadre pourrait être complété par symétrie et entourer ainsi complètement le barreau 14.

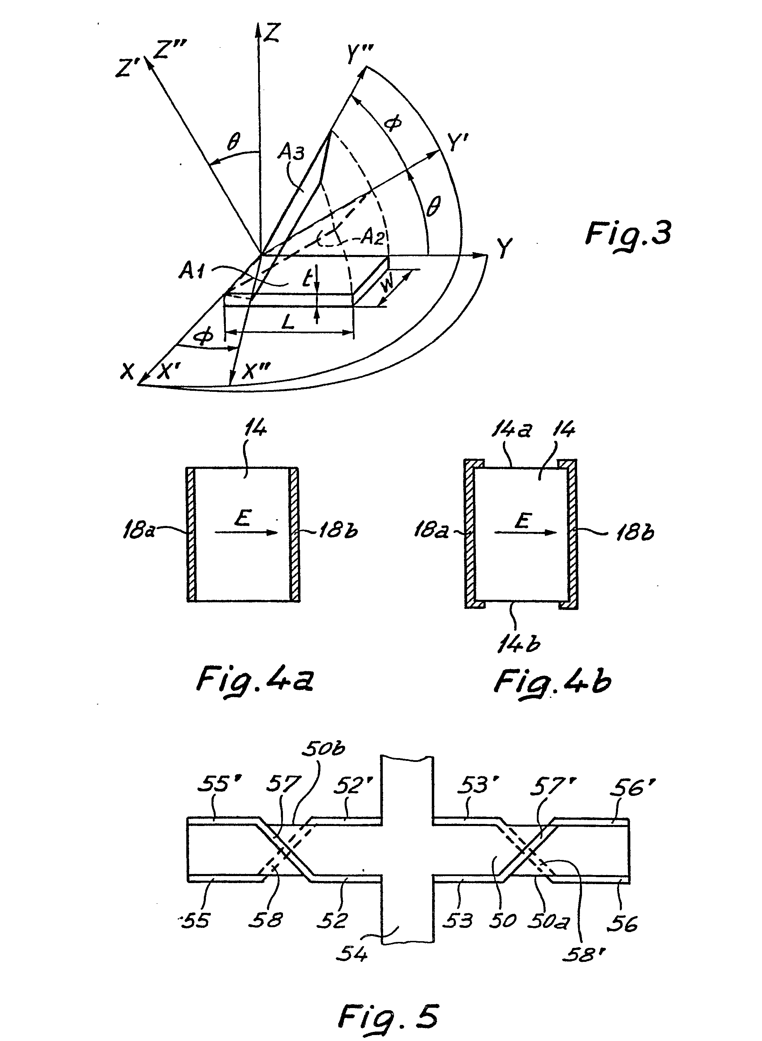

Les métallisations 18a et 18b forment les électrodes d'excitation du barreau 14. Selon l'invention, le barreau 14, les bras 16a et 16b sont taillés dans une même plaque de quartz perpendiculaire à l'axe optique Z du quartz et le barreau est disposé selon l'axe électrique Ydu quartz. Ainsi, comme le montre clairement la figure 4a, le champ électrique créé par les électrodes 18a et 18b est effectivement parallèle à l'axe électrique X du quartz et le couplage piézo-électrique obtenu est très bon. La figure 4b montre que les métallisations peuvent légèrement déborder sur les faces supérieure et inférieure 14a et 14b du quartz sans que cela perturbe sensiblement la direction du champ électrique créé dans le quartz. Il est donc clair que, lors de la réalisation des électrodes 18a et 18b, la définition des bords supérieurs et inférieurs de ces métallisations n'est pas critique.

La figure 3 illustre une coupe sensiblement de type Z utilisable pour réaliser le résonateur. Cette coupe est du type zywt. La figure 3 illustre les deux rotations définissant le plan de coupe. La référence $A_1$ représente la position initiale de la plaquette de quartz par rapport aux axes X, Y et Z.La première rotation est effectuée autour de l'axe X. On appellera $\Theta$ l'angle de rotation. La référence $A_2$ donne la position intermédiaire de la plaquette avec les axes $X'$ = X, Y' et Z'. La deuxième rotation est effectuée autour de l'axe Z'. On appellera $\phi$ l'angle de rotation. La référence $A_3$ donne la position finale de la plaquette avec les axes X'', Y'' et Z'' = Z'. L'angle $\Theta$ est inférieur à 20° en valeur absolue, et l'angle $\phi$ est inférieur à 30° en valeur absolue. De préférence, pour les applications horlogères, l'angle $\phi$ est nul et l'angle $\Theta$ est compris entre 0° et —10°. Par exemple, l'angle $\Theta$ vaut —2°.

Cette coupe conserve tous les avantages d'une coupe Z tout en présentant un coefficient $\alpha$ de température plus favorable.

On sait que la fréquence f d'un quartz à la température T est donnée par la relation $f(T) = f(T_o) [1 + \alpha (T - T_o) + \beta (T - T_o)^2 + \gamma (T - T_o)^3 + ..]$. Le coefficient $\alpha$ est donc le coefficient du terme du premier degré dans la relation entre les variations relatives de fréquence et les variations de température, $T_o$ étant une température de référence.

On a réalisé un résonateur selon l'invention, de fréquence propre 1 M Hz, avec les caractéristiques suivantes:

L (longueur d'électrode = longueur du barreau) = 2,75 mm

w (largeur du barreau) = 0,1 mm

t (épaisseur du barreau) = 0,2 mm

Un tel résonateur présente une capacité dynamique $C_1$ = 1,88 fF, à comparer avec les 0,1 fF des résonateurs selon l'art antérieur. Il faut observer de plus que, du fait qu'il n'y a plus de métallisations fonctionnelles sur les faces du barreau, celui-ci peut avoir une largeur très faible, même inférieure à son épaisseur. Cette largeur de 0,1 mm est à comparer aux 4,2 mm du résonateur de 780 k Hz de l'art antérieur. Cette réduction de la largeur a une influence déterminante sur l'amélioration de $C_1$. Pour faire travailler de tels résonateurs à des fréquences supérieures (jusqu'à 4 M Hz) tout en conservant des longueurs de barreau usinable, on utilise la technique dite de «l'over-tone» ou en «harmonique». La figure 5 illustre un résonateur selon l'invention apte à travailler selon cette technique.

Chaque flanc du barreau comporte trois électrodes distinctes réparties sur la longueur du barreau. Sur un des flancs 50a du barreau 50, on trouve un électrode centrale en deux parties 52 et 53 disposées de chaque côté du bras support 54. On trouve également deux électrodes 55 et 56 disposées à proximité de chacune des extrémités du barreau. Les électrodes 52, 53, 55 et 56 ont toutes sensiblement la même longueur. Vis-à-vis des électrodes 52, 53, 55 et 56 sont disposées des électrodes 52', 53', 55' et 56' sur le flanc 50b du barreau 50. Des connexions électriques 57 et 57' réalisées sur la face supérieure du barreau relient l'électrode centrale 52, 53 aux électrodes 55' et 56', alors que des connexions électriques 58 et 58' disposées sur la face inférieure relient l'électrode centrale 52', 53' aux électrodes 55 et 56. Ainsi sont réalisés trois groupes de deux électrodes se faisant face et créant dans le barreau des champs électriques égaux mais de sens différents pour deux groupes adjacents. On trouve le groupe central 52, 53 et 52', 53' et les groupes extrêmes 55, 55' et 56, 56'. Ainsi, si $f_o$ est la fréquence qu'aurait le barreau s'il était pourvu d'une électrode sur chacun de ses flancs, la fréquence du barreau excité par le système d'électrodes représenté sur la figure 5 serait $f'$ = $3f_o$. De manière analogue, il serait possible d'obtenir les fréquences $5f_o$, $7f_o$, etc.... pour une même longueur de barreau ($f'$ = $nf_o$, n étant un nombre impair).

En outre, la fabrication des résonateurs selon l'invention peut se faire par des techniques bien connues dans le domaine de l'usinage du quartz. En particulier, les métallisations ayant une définition géométrique non critique, leur réalisation ne nécessite pas d'étapes de masquage exigeant une très grande précision de positionnement.

Il faut ajouter que les dimensions du barreau doivent être choisies pour éviter que les fréquences des modes partiels de flexion ne coïncident avec la fréquence d'extension-compression W.

En respectant ces conditions, on obtient effectivement un barreau vibrant en mode principal d'extension-compression.

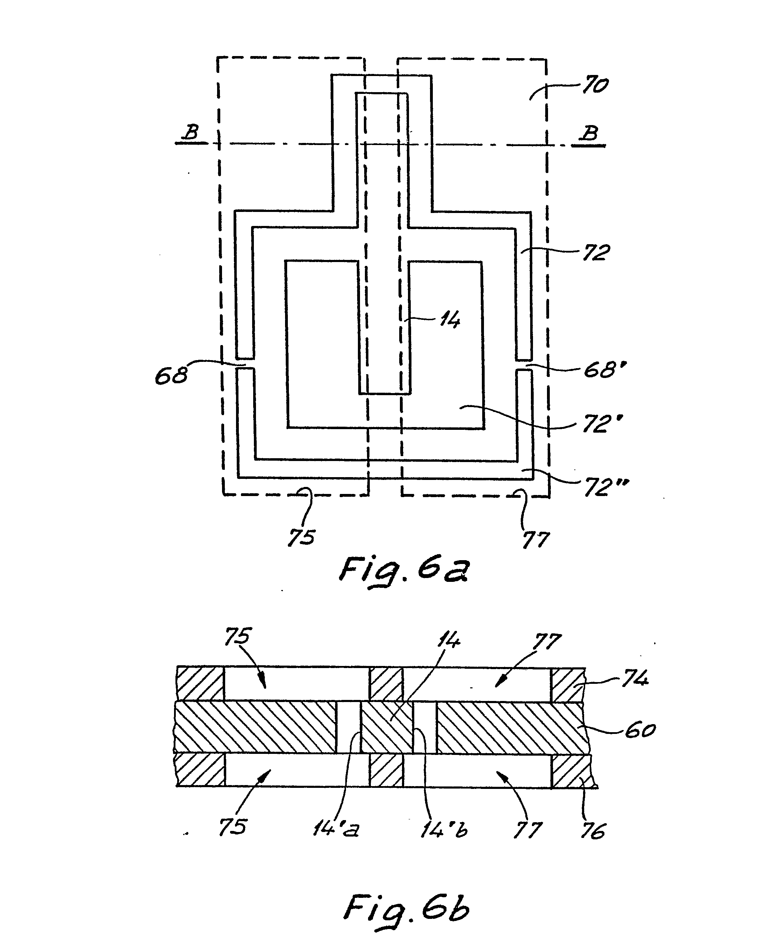

La figure 6a est une vue de dessus d'un résonateur selon l'invention en cours de fabrication, et la figure 6b est une vue de ce résonateur en coupe verticale par le plan référencé B à la figure 6a. Ces figures 6a et 6b illustrent un procédé possible de réalisation de résonateurs selon l'invention.

On part d'une plaquette de quartz 60 de coupe Z, comme cela a été expliqué en liaison avec la figure 3. Cette plaquette a une épaisseur uniforme de 100 à 200 $\mu$m. Comme cela est bien connu, on dépose par photolithographie une couche d'un alliage chrome-or, ayant la silhouette du barreau 14 et de l'ensemble de fixation. On réserve également des points d'attache 68, 68' très fragiles avec le reste 70 de la plaque qui est utilisée pour réaliser simultanément d'autres résonateurs.

La plaquette 60 est ensuite trempée dans un bain d'attaque chimique (par exemple d'acide fluorhydrique) de sorte que les parties non protégées par la métallisation sont dissoutes, ce qui donne les fentes 72, 72' et 72''. Il ne reste donc plus que le barreau 14 avec son ensemble de fixation relié au reste de la plaque par les points d'attache 68 et 68'. La métallisation ayant servie de masque est ensuite enlevée dans un bain adéquat.

Puis on réalise les métallisations des flancs 14'a et 14'b du barreau pour former les électrodes, ainsi que les métallisations des bras 20a et 20b de la manière suivante:

On réalise des plaques de masquage 74 et 76 présentant des ouvertures sensiblement rectangulaires 75 et 77, telles que, après avoir placé ces masques 74 et 76 de part et d'autre de la plaquette 60, les flancs 14'a et 14'b du barreau ainsi que les bras soient dégagés. C'est ce que montre la figure 6b. En revanche, les faces supérieure et inférieure du barreau sont masquées au moins partiellement. En soumettant cet ensemble à un jet de métal évaporé, on réalise les métallisations des flancs, c'est-à-dire les électrodes, et les métallisations des bras. La figure 6b montre que le positionnement des masques 74 et 76 n'est pas critique puisqu'il suffit que creux-ci recouvrent la partie centrale du barreau 14 pour séparer effectivement les deux électrodes. En outre, du fait de la coupe Z de la plaquette 60, la gravure chimique du quartz se fait aisément et avec une bonne définition. Il apparaît aussi clairement que ce procédé s'applique bien à la réalisation d'un grand nombre de résonateurs à partir d'une même plaquette de quartz.

Il va également de soi que le dépôt des métallisations et la définition des métallisations sur les flancs formant les électrodes pourrait se faire différemment. Le procédé décrit paraît cependant particulièrement bien adapté à la réalisation en grande quantité des résonateurs selon l'invention, par exemple pour des montres électroniques, analogiques ou numériques.

**Revendications**

1. Micro-résonateur piézo-électrique (10) pour vibrer selon un mode principal d'extension-compression comprenant un barreau (14) et un ensemble de suspension (16a, 16b, 24a, 24b, 24c) ne faisant qu'une pièce avec ledit barreau (14), la longueur (L) du barreau étant disposée sensiblement selon l'axe mécanique Y et les flancs du barreau étant sensiblement parallèles à l'axe optique Z du matériau piézo-électrique, et des métallisations conductrices (18a, 18b) formant des électrodes d'excitation du barreau, caractérisé en ce que lesdites métallisations (18a, 18b) sont réalisées sur lesdits flancs (14'a, 14'b) pour que chaque flanc (14'a, 14'b) soit muni d'au moins une électrode raccordée à une métallisation (20a, 20b) déposée sur ledit ensemble de suspension (16a, 16b, 24a, 24b, 24c).

2. Micro-résonateur selon la revendication 1, caractérisé en ce que ledit ensemble de suspension comprend deux bras (16a, 16b) disposés de part et d'autre dudit barreau (14) et en ce que lesdits (16a, 16b) bras sont raccordés au barreau (14) sensiblement à mi-longueur de celui-ci.

3. Micro-résonateur selon l'une quelconque des revendications 1 et 2, caractérisé en ce que chaque flanc (14'a, 14'b) est muni d'une seule électrode (18a, 18b) s'étendant substantiallement sur la totalité dudit flanc (14'a, 14'b).

4. Micro-résonateur selon l'une quelconque des revendications 1 et 2, caractérisé en ce que chaque flanc comprend une électrode centrale (52, 53, 52', 53', fig. 5) disposée de part et d'autre du bras (54, fig. 5) et 2n électrodes supplémentaires (55, 55', 56, 56', fig. 5), une électrode d'un flanc faisant face à une électrode d'un autre flanc pour former une paire d'électrodes, deux paires d'électrodes consécutives étant polarisées pour créer dans le barreau des champs électriques de même direction mais de sens opposés.

5. Micro-résonateur selon l'une quelconque des revendications 1 à 4, caractérisé en ce que l'épaisseur du barreau (t) selon l'axe Z est supérieure à la largeur (w) du barreau selon l'axe X du matériau piézoélectrique.

6. Résonateur selon l'une quelconque des revendications 1 à 5, caractérisé en ce que ledit barreau (14) et ledit ensemble de suspension (16a, 16b, 24a, 24b, 24c) sont réalisés en quartz, en ce que lesdits flancs sont parallèles à un axe Z', et en ce que l'angle entre ledit axe Z' et l'axe Z du quartz est inférieur à 20° en valeur absolue.

## Patentansprüche

1. Piezoelektrischer Mikroresonator (10) für Schwingungen gemäss einem Haupt-Dehnungskompressions-Modus mit einem Stab (14) und einer Aufhängung (16a, 16b, 24a, 24b, 24c), die mit dem Stab (14) nur ein Teil bildet, wobei die Länge (L) des Stabes im wesentlichen in Richtung der mechanischen Y-Achse angeordnet ist und die Seitenflächen des Stabes im wesentlichen parallel der optischen Z-Achse des piezoelektrischen Materials verlaufen, und mit leitenden Metallisierungen (18a, 18b), die Erregerelektroden des Stabes bilden, dadurch gekennzeichnet, dass die Metallisierungen (18a, 18b) auf den Seitenflächen (14'a, 14'b) ausgebildet sind, derart, dass jede Seitenfläche (14'a, 14'b) mindestens eine Elektrode aufweist, die an eine auf der Aufhängung (16a, 16b, 24a, 24b, 24c) angeordneten Metallisierung (20a, 20b) angeschlossen ist.

2. Mikroresonator nach Anspruch 1, dadurch gekennzeichnet, dass die Aufhängung zwei Arme (16a, 16b) umfasst, die beidseits des Stabes (14) angeordnet sind und dass die beiden Arme (16a, 16b) mit dem Stab etwa in der Mitte seiner Länge verbunden sind.

3. Mikroresonator nach Anspruch 1 oder 2, dadurch gekennzeichnet, dass jede Seitenfläche (14'a, 14'b) eine einzige Elektrode (18a, 18b) aufweist, die sich im wesentlichen über die gesamte Seitenfläche (14'a, 14'b) erstreckt.

4. Mikroresonator nach Anspruch 1 oder 2, dadurch gekennzeichnet, dass jede Seitenfläche eine zentrale Elektrode (52, 53, 52', 53', Fig. 5), die auf beiden Seiten des Armes (54, Fig. 5) angeordnet ist, und 2n zusätzliche Elektroden (55, 55', 56, 56', Fig. 5) umfasst, wobei eine Elektrode einer Seitenfläche einer Elektrode einer anderen Seitenfläche gegenüberliegt, um ein Elektrodenpaar zu bilden, wobei zwei aufeinanderfolgende Elektrodenpaare polarisiert sind, um in dem Stab elektrische Felder derselben Richtung, aber entgegengesetzten Vorzeichens zu erzeugen.

5. Mikroresonator nach einem der Ansprüche 1 bis 4, dadurch gekennzeichnet, dass die Dicke (t) des Stabes in Richtung der Z-Achse grösser ist als die Breite (w) des Stabes in Richtung der X-Achse des piezoelektrischen Materials.

6. Mikroresonator nach einem der Ansprüche 1 bis 5, dadurch gekennzeichnet, dass der Stab (14) und die Aufhängung (16a, 16b, 24a, 24b, 24c) aus Quarz sind, dass die Seitenflächen parallel einer Z'-Achse verlaufen und dass der Winkel zwischen der Z'- und der Z-Achse des Quarzes kleiner als 20° Absolutwert beträgt.

## Claims

1. A piezoelectric micro-resonator (10) adapted to vibrate in a principal extension-compression mode, comprising a bar (14) and a suspension arrangement (16a, 16b, 24a, 24b, 24c) integral with said bar (14), the length (L) of the bar being disposed substantially along the mechanical axis Y and the flanks of the bar being substantially parallel to the optical axis Z of the piezoelectric material, and conductive metallizations (18a, 18b) forming electrodes for exciting the bar, characterized in that said metallizations (18a, 18b) are so provided on said flanks (14'a, 14'b) that each flank (14'a, 14'b) has at least one electrode connected to a metallization (20a, 20b) deposited on said suspension arrangement (16a, 16b, 24a, 24b, 24c).

2. A micro-resonator according to claim 1, characterized in that said suspension arrangement comprises a pair of arms (16a, 16b) disposed on opposite sides of said bar (14) and in that said arms (16a, 16b) are connected to the bar (14) substantially halfway therealong.

3. A micro-resonator according to any one of claims 1 and 2, characterized in that each flank (14'a, 14'b) has a single electrode (18a, 18b) extending substantially over the entire said flank (14'a, 14'b).

4. A micro-resonator according to any one of claims 1 and 2, characterized in that each flank comprises a central electrode (52, 53, 52', 53', figure 5) disposed on opposite sides of the arm (54, figure 5) and 2n supplementary electrodes (55, 55', 56, 56', figure 5), with one electrode on one flank facing an electrode on another flank to form a pair of electrodes, two consecutive pairs of electrodes being polarized to set up in the bar electric fields having opposite directions.

5. A micro-resonator according to any one of claims 1 to 4, characterized in that the thickness (t) of the bar along the Z axis is greater than the width (w) of the bar along the X axis of the piezoelectric material.

6. A micro-resonator according to any one of claims 1 to 5, characterized in that said bar (14) and said suspension arrangement (16a, 16b, 24a, 24b, 24c) are made of quartz, in that said flanks are parallel to an axis Z', and in that the angle between said Z' axis and the Z axis of the quartz is less than 20° in absolute value terms.

0 056 783

Fig.1

Fig.2

7

0 056 783

Fig.3

Fig.4a

Fig.4b

Fig.5

9

Fig.6a

Fig.6b